Europäisches Patentamt

European Patent Office

Office européen des brevets

(11) Publication number: **0 058 050**
**B1**

(12) **EUROPEAN PATENT SPECIFICATION**

(45) Date of publication of patent specification: **15.05.85**

(51) Int. Cl.⁴: **G 01 R 23/02**

(21) Application number: **82300552.5**

(22) Date of filing: **03.02.82**

(54) Measuring method.

(30) Priority: **10.02.81 JP 18609/81**

(43) Date of publication of application:
**18.08.82 Bulletin 82/33**

(45) Publication of the grant of the patent:
**15.05.85 Bulletin 85/20**

(84) Designated Contracting States:
**CH DE GB LI SE**

(56) References cited:

**ELECTRONICS LETTERS, Vol.14, No. 12, June
1978, Hitchin M.J. UNDERHILL et al. "Fast-
Sampling Frequency Meter" pages 366, 367
FREQUENZ, Vol. 27, no. 11, 1973 Berlin K.-H.
JUTZI "Frequenzbestimmung durch
Signalabtastung" pages 309 to 311**

(73) Proprietor: **MITSUBISHI DENKI KABUSHIKI
KAISHA
2-3, Marunouchi 2-chome Chiyoda-ku
Tokyo 100 (JP)**

(72) Inventor: **Suzuki, Sunao
74-25, Takatsu cho Tarumi-ku
City of Kobe Hyogo Prefecture (JP)**
Inventor: **Maeda, Koji
3-10-19, Nanpei-dai
City of Takatsuki Osaka (JP)**

(74) Representative: **Lawson, David Glynne et al
MARKS & CLERK 57-60 Lincoln's Inn Fields
London WC2A 3LS (GB)**

Note: Within nine months from the publication of the mention of the grant of the European patent, any person may
give notice to the European Patent Office of opposition to the European patent granted. Notice of opposition shall
be filed in a written reasoned statement. It shall not be deemed to have been filed until the opposition fee has been
paid. (Art. 99(1) European patent convention).

Courier Press, Leamington Spa, England.

## Description

This invention relates to a frequency calculating method for measuring the frequency of, for example, an electric power system by digitally processing an electrical quantity, for example a voltage magnitude thereof.

A conventional frequency detection system counts pulses during half cycles of the a.c. in an electric power system, and compares the count with a frequency in a binary form stored in a memory to determine whether the frequency of the electric power system is higher or lower than the stored frequency. Such a system is not able to detect the absolute value of the frequency.

In measuring systems including a computer to measure electrical quantities, measurement of frequency requires the use of a special instrument. However such an instrument could not be assembled in an associated computer system.

Accordingly it is an object of this invention to provide a new and improved frequency measuring system for measuring the frequency of an electric power system and also determining the absolute value thereof.

According to a basic idea of the present invention, an AC input having a frequency to be measured is sampled with a predetermined constant sampling period to form four consecutive samples from which is calculated a quantity dependent only on and constituting a measure of the frequency.

More specifically, the present invention provides a method of measuring the frequency f of a sine wave AC input signal $V(t)$ of substantially constant peak amplitude, comprising sampling the amplitude of the said signal at a predetermined number of time points which occur within one cycle of the signal and are separated by a predetermined sampling period h to derive a corresponding plurality of sampling signals, and calculating the frequency of the input signal from the said sampling signals, characterised in that in one cycle only four sampling signals are derived which respectively represent the amplitudes $V(t_0-2h)$, $V(t_0-h)$, $V(t_0+h)$ and $V(t_0+2h)$ measured at respective time points $(t_0-2h)$, $(t_0-h)$, $(t_0+h)$ and $(t_0+2h)$, where $t_0$ designates any desired time point, and these sampling signals are applied to calculating means which calculates the quantity $y(h)$ given by:

$$y(h) = \frac{V(t_0+2h)-V(t_0-2h)}{V(t_0+h)-V(t_0-h)} = 2\cos\omega h$$

where $\omega = 2\pi f$ is the angular frequency of the input signal, thereby providing a measure of the frequency of said AC input.

The article "Frequenzbestimmung durch Signalabtastung" (Frequency measurement by signal sampling) in the periodical "Frequenz" Volume 27, No. 11, 1973 pages 309 to 311, Berlin, describes a method of calculating the frequency of a sine-wave input signal using a sampling method with three samples. In the method described in this publication, the frequency is determined from the relation:

$$\frac{1}{2\pi h} \arccos \frac{V(t_0)+V(t_0+2h)}{2V(t_0+h).}$$

The present invention will be further described in conjunction with the accompanying drawings, in which:

Figure 1 is a graph useful in explaining the sampling according to the present invention, and

Figure 2 is a block diagram of one embodiment of the frequency detection system of the present invention.

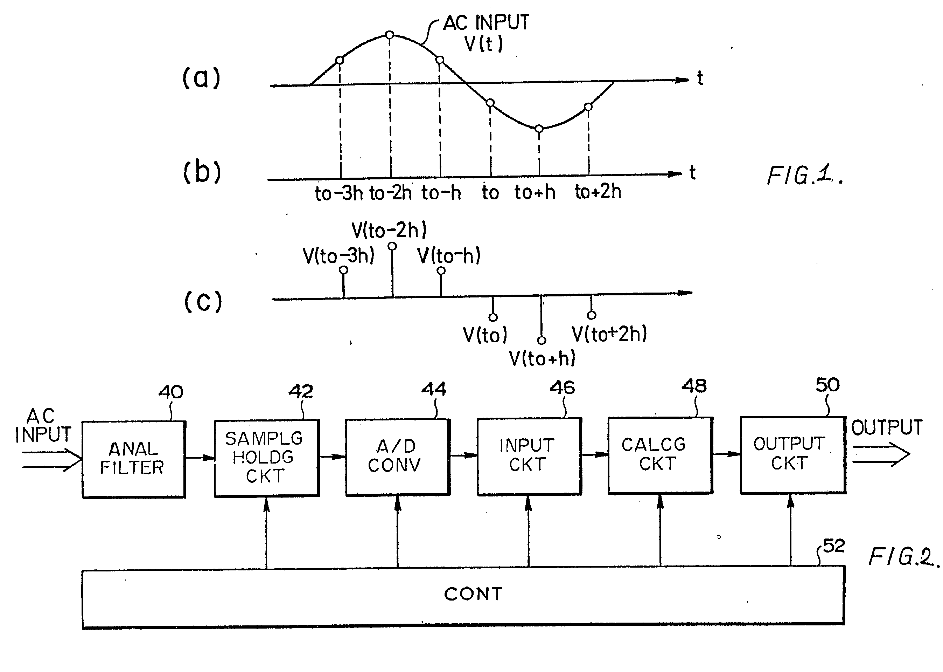

Figure 1 shows the manner in which the AC input is sampled in accordance with the present invention while Figure 2 is a block diagram of an embodiment of the present invention. In Figure 1 the uppermost portion (a) shows an AC input in the form of a sinusoidal wave having a frequency to be determined, the intermediate portion (b) shows sampling positions disposed at predetermined equal intervals h along the time axis t and the lowest portion (c) shows values of the AC input sampled at the sampling positions.

It is assumed that the AC input $V(t)$ is expressed by

$$V(t) = \sin\omega t$$

where V designates the peak value of the AC input and $\omega t$ designates the angular frequency thereof. The AC input is sampled at time points $t_0-2h$, $t_0-h$, $t_0+h$ and $t_0+2h$ respectively where $t_0$ designates any desired time point. The sampled values may be expressed by

$$V(t_0-2h) = V\sin\omega(t_0-2h) \tag{1}$$

$$V(t_0-h) = V\sin\omega(t_0-h) \tag{2}$$

2

$$V(t_o+h)=V\sin\omega(t_o+h) \qquad\qquad (3)$$

and

$$V(t_o+2h)-V\sin\omega(t_9+2h) \qquad\qquad (4)$$

respectively. The sampled values are used to form a quantity y(h) defined as:

$$y(h)=\frac{V(t_o+2h)-V(t_o-2h)}{V(t_o+h)-V(t_o-h)} \qquad\qquad (5)$$

therefore:

$$y(h)=\frac{\sin\omega(t_o+2h)-\sin\omega(t_o-2h)}{\sin\omega(t_o+h)-\sin\omega(t_o-h)}$$

$$=\frac{\sin\omega t_o\cos2\omega h+\cos\omega t_o\sin2\omega h-\sin\omega t_o\cos2\omega h+\cos\omega t_o\sin2\omega h}{\sin\omega t_o\cos\omega h+\cos\omega t_o\sin\omega h-\sin\omega t_o\cos\omega h+\cos\omega t_o\sin\omega h}$$

$$=\frac{2\cos\omega t_o\sin2\omega h}{2\cos\omega t_o\sin\omega h}$$

$$=2\cos\omega h \qquad\qquad (6)$$

From the expression (6) it is seen that y(h) is independent of the peak value $V$ of the AC input and is a function of the angular frequency $\omega$ alone, because the sampling interval or period $h$ is a constant. Since the angular frequency $\omega$ is defined by $\omega=2\pi f$ where $f$ designates the frequency of the AC input, the expression (6) has a value determined only by the frequency $f$. By substituting for $\omega$ and solving the expression (6) with respect to $f$ we get:

$$f=\frac{1}{2\pi h}\ \text{arccos}\ \frac{y(h)}{2} \qquad\qquad (7)$$

Thus one can directly calculate the frequency from the expression (7). That is, one can measure the absolute value of the frequency, by determining the arccosine of the quantity y(h) computer from the sampled values of the AC input.

Figure 2 shows one embodiment of the frequency measuring system of the present invention, for effecting the sampling and calculations as described above. The arrangement illustrated comprises an analog filter 40, a sampling and holding circuit 42 and an analog-to digital converter circuit 44 connected in series in the above-mentioned order.

An AC input waveform as shown in Figure 1a is passed through the analog filter 40 which eliminates frequencies that might disturb the sampling and holding circuit 42, which samples the input signal with the sampling period $h$ to form sampled values $V(t_o-2h)$, $V(t_o-h)$, $V(t_o+h)$ and $V(t_o+2h)$ as described above in conjunction with Figure 1. These sampled values are temporarily held in the circuit 42 and are then successively applied to the analog-to-digital converter circuit 44 where they are converted to corresponding digital values.

The converted digital values are supplied to an input circuit 46 forming a computer with a calculating circuit 48 and an output circuit 50 connected in series with each other. The calculating circuit 48 performs the calculations in accordance with the above expressions (5) and (7) to determine the frequency of the AC input. The frequency thus determined appears at the output circuit 50.

The components 42, 44, 46, 48 and 50 are connected to a control circuit 52.

## Claims

1. A method of measuring the frequency f of a sine wave AC input signal V(t) of substantially constant peak amplitude, comprising sampling the amplitude of the said signal at a predetermined number of time points which occur within one cycle of the signal and are separated by a predetermined sampling period h to derive a corresponding plurality of sampling signals, and calculating the frequency of the input signal from the said sampling signals, characterised in that in one cycle four sampling signals are derived which respectively represent the amplitudes $V(t_o-2h)$, $V(t_o-h)$, $V(t_o+h)$ and $V(t_o+2h)$ measured at respective time points $(t_o-2h)$, $(t_o-h)$, $(t_o+h)$ and $(t_o+2h)$, where $t_o$ designates any desired time point, and these sampling signals are applied to calculating means which calculates the quantity y(h) given by:

$$y(h)=\frac{V(t_o+2h)-V(t_o-2h)}{V(t_o+h)-V(t_o-h)}=2\cos\omega h$$

where $\omega=2\pi f$ is the angular frequency of the input signal, thereby providing a measure of the frequency of said AC input.

2. A frequency measuring method as claimed in claim 1 characterised in that the absolute value of the frequency is calculated by calculating the arccos function of the quantity $y(h)$:

$$f=\frac{1}{2\pi h}\ arccos\ \frac{y(h)}{2}$$

**Patentansprüche**

1. Verfahren zur Messung der Frequenz eines Wechselstrom- Sinuswelleneingangssignals V(t) mit im wesentlichen konstanter Spitzenamplitude, welche das Abtasten der Amplitude dieses Signals an einer vorbestimmten Anzahl von Zeitpunkten, welche innerhalb eines Signalzyklus auftreten und welche durch eine vorbestimmte Tastperio- de h getrennt sind, um eine entsprechende Anzahl von Tastsignalen zu erhalten, und die Berechnung der Fre- quenz des Eingangsignals von diesen Tastsignalen um- fasst, dadurch gekennzeichnet, dass in einem Zyklus vier Tastsignale abgeleitet werden, welche die Amplituden $V(t_o-2h)$, $T(t_o-h)$, $V(t_o+h)$ und $V(t_o+2h)$ gemessen an den entsprechenden Zeitpunkten $(t_o-2h)$, $(t_o-h)$, $(t_o+h)$ und $(t_o+2h)$ repräsentieren, wobei $t_o$ irgend einen gewünschten Zeitpunkt bezeichnet, und wobei diese Tastsignale einer Recheneinrichtung zuge- führt sind, welche die Grösse $y(h)$ berechnet nach:

$$y(h)=\frac{V(t_o+2h)-V(t_o-2h)}{V(t_o+h)-V(t_o-h)}=2\cos\omega h,$$

wobei $\omega=2\pi f$ die Winkelfrequenz des Eingangssignals ist, und hiermit ein Mass für die Frequenz dieses Wechselstromeingangs ist.

2. Verfahren zur Messung der Frequenz nach Anspruch 1, dadurch gekennzeichnet, dass der Absolutwert der Frequenz durch die Bestimmung der arccos Funktion der Grösse $y(h)$ aus

$$f=\frac{1}{2\pi h}\ arccos\ \frac{y(h)}{2}$$

berechnet wird.

**Revendications**

1. Procédé de mesure de la fréquence f d'un signal d'entrée de courant alternatif de forme sinusoidale V(t) ayant une amplitude de crête sensiblement constante, comprenant un échantillonnage de l'amplitude de ce signal à un nombre prédéterminé de points de temps au cours d'un cycle du signal, ces points étant séparés par une période d'échantillonnage h prédéterminée afin de dériver une série correspondante de signaux d'échantillonnage, et le calcul de la fréquence du signal d'entrée desdits signaux d'échantillonnage, caractérisé en ce que, pendant un cycle, l'on mesure quatre signaux d'échantillonnage représentant respectivement les amplitudes $V(t_o-2h)$, $V(t_o-h)$, $V(t_o+h)$ et $V(t_o+2h)$ mesurées aux points de temps $(t_o-2h)$, $(t_o-h)$, $(t_o+h)$ et $(t_o+2h)$ correspondants, où $t_o$ représente un point de temps déterminé, ces signaux d'échantillonnage étant utilisés au calcul de la valeur $y(h)$ selon la relation:

$$y(h)=\frac{V(t_o+2h)-V(t_o-2h)}{V(t_o+h)-V(t_o-h)}=2\ \cos\omega h,$$

d'où, $\omega=2\pi f$ étant la fréquence angulaire du signal d'entrée, l'on obtient la mesure de la fréquence d'entrée du courant alternatif.

2. Procédé de mesure de fréquence selon la revendication 1, caractérisé en ce que le valeur absolue de la fréquence est calculée à partir de la fonction arccos de la valeur $y(h)$ selon la relation:

$$f=\frac{1}{2\pi h}\ arccos\ \frac{y(h)}{2}$$

(a) AC INPUT
V(t)

(b) t
to-3h to-2h to-h  to  to+h  to+2h

FIG.1.

V(to-2h)
V(to-3h)  V(to-h)
(c)
V(to)  V(to+2h)
V(to+h)

| AC INPUT | ANAL FILTER 40 | SAMPLG HOLDG CKT 42 | A/D CONV 44 | INPUT CKT 46 | CALCG CKT 48 | OUTPUT CKT 50 | OUTPUT |

CONT 52

FIG.2.

0 058 050